Europäisches Patentamt

European Patent Office

Office européen des brevets

(11) Veröffentlichungsnummer: **0 402 691**

**A1**

## (12) EUROPÄISCHE PATENTANMELDUNG

(21) Anmeldenummer: **90110110.5**

(22) Anmeldetag: **28.05.90**

(51) Int. Cl.5: **H01S 3/085, G01D 5/26**

(30) Priorität: **29.05.89 DE 3917388**

(43) Veröffentlichungstag der Anmeldung:
**19.12.90 Patentblatt 90/51**

(84) Benannte Vertragsstaaten:
**CH ES FR GB IT LI NL SE**

(71) Anmelder: **POLYTEC GESELLSCHAFT FÜR ANALYSEN-, MESS-& REGEL-TECHNIK mbH & CO.**
**Siemensstrasse 15**
**D-7517 Waldbronn(DE)**

(72) Erfinder: **Thiessen, Rainer, Dipl.-Ing.**
**Freiburger Platz 3**
**D-8000 München 21(DE)**

(74) Vertreter: **Lemcke, Rupert, Dipl.-Ing. et al**
**Patentanwälte Dipl.-Ing. R. Lemcke Dr.-Ing.**
**H.J. Brommer Bismarckstrasse 16 Postfach 4026**
**D-7500 Karlsruhe 1(DE)**

(54) **Laser-Sensor mit externem Resonator.**

(57) Laser-Sensor mit externem Resonator zur Messung von Länge, Winkel und Brechungsindex mit Richtungserkennung der zu messenden Größen unter anderem auch durch Modulation.

Fig.1

## Laser-Sensor mit externem Resonator

Die Erfindung bezieht sich auf einen Laser-Sensor mit einem durch einen externen Reflektor begrenzten externen Resonator, bei dem das vom Laser ausgesandte Licht den externen Resonator durchsetzt und wieder in den Laser zurückreflektiert wird, so daß die Zustände bzw. Zustandsänderungen im externen Resonator zur Beeinflussung der Lichterzeugung im Laser führen und daher durch Beobachtung der Lichterzeugung des Lasers gemessen werden können.

Damit ist es möglich, die Längenänderung des externen Resonators, eine Winkelabweichung des externen Reflektors gegenüber der optischen Achse, und vor allem die Rechtwinklichkeit des externen Reflektors gegenüber der optischen Achse, zu prüfen, ebenso kann man den Brechungsindex n des Mediums messen, das sich in dem vom Laserstrahl durchsetzten Raum des externen Resonators befindet.

Laser, und speziell Halbleiterlaser mit externen Resonatoren sind als Sender für verschiedenene technische Systeme, auch Längen- und Winkelmeßsysteme und Interferometer bekannt und beschrieben,

(z.B. EP 0206745, 0090485, 0140820, 0257898, 0206661, 0213965) dabei dient der externe Resonator zur gezielten Steuerung der Sendeeigenschaften des Lasers, auch die Modulation solcher Systeme ist beschrieben, z.B. von

E.M.Strzelecki et.al. in "Journal of Lightwave Technology" Vol.6, Nr.10, Okt. 1988, S.1610-18, wo ein modulierter Laserstrahl für ein LIDAR-Entfernungsmeßgerät erzeugt wird.

In all diesen Systemen ist aber der Laser als Sender und das Meßgerät selbst getrennt, eine Rückstrahlung des Lichts in den Laser wird nicht zur Messung benutzt.

Eine solche Anwendung, der also der Laser mit externem Resonator als Sensor selbst benutzt wird, und die Beobachtung der Rückwirkung des ext. Resonators auf den Laser in Abhängigkeit der zu messenden Größe zur Messung derselben herangezogen wird, ist jedoch ebenfalls beschrieben, wie von R.O.Miles et.a. in "Journal of Lightwave Technology" Vol.LT-1, Nr.1, März 1983, S. 81-93.

Dort sieht man auf S.85, wie z.B. die Veränderung der Länge des externen Resonators zu periodischen Schwankungen in der Intensität des vom Laser emittierten Lichts führt.

Aus der Beobachtung dieser Schwankungen kann aber nicht auf die Richtung der Längenänderung geschlossen werden, man weiß also nicht, ob der ext. Resonator länger oder kürzer wird, oder ob, im schlimmsten Fall, der externe Reflektor um eine Ruhelage herum schwingt und dadurch Intensitätschwankungen erzeugt, die eine Bewegung vortäuschen, was bei Empfindlichkeiten im nm-Bereich häufig der Fall ist.

Diese Eigenschaften schränken die praktische Verwendbarkeit solcher Sensoren sehr stark ein.

Es wurden bisher auch nur Längenänderung und Winkelverkippung mit externen Resonatoren gemessen.

Zu erwähnen ist hier die Patentschrift DE 3606090 A1, in deren Fig.2 die im vorliegenden Anspruch 1 beschriebene richtungsabhängige Signalform der auftretenden periodischen Intensitätsschwankungen gezeichnet, aber nicht zur Richtungserkennung verwendet wird; Stattdessen wird hier ein Amplitudenoffset ausgewertet.

Der vorliegenden Erfindung liegt, ausgehend von diesem Stand der Technik, die Aufgabe zugrunde, solche Nachteile und Einschränkungen zu beseitigen und,

zum einen,

eine Richtungserkennung der Änderung der zu messenden Größen zu ermöglichen, wobei neben der Längenänderung des externen Resonators auch die Winkelabweichung des externen Reflektors gegenüber der optischen Achse und der Brechungsindex des Mediums im externen Resonator meßbar sind, ferner die Auflösung, die Stabilität und die Justierbarkeit der Sensoren zu erhöhen, und, zum anderen,

als externe Reflektoren nicht nur optische Elemente zu verwenden, sondern auch andere reflektierende Flächen.

Diese Aufgabe wird mit einem Laser-Sensor mit externem Resonator gelöst, bei dem die Form der Lichtintensitätsschwankungen, die durch die Meßgröße entstehen, zur Richtungserkennung ausgewertet wird, oder durch Modulation der, im folgenden "Lasersystem" genannten Einheit aus Laser und externem Resonator, wobei die Verschiebung der Lichtintensitätsschwankungen gegenüber dem Modulationssignal zur Bestimmung der Meßgröße und deren Richtung benutzt wird.

Neu ist bei dieser Erfindung also die Richtungserkennung für die zu messende Größe durch Auswertung der Form der auftretenden Signale, bzw. durch Modulation des Lasersystems, wobei nicht nur die Modulation der inkrementell zu messenden Größe, also z. B. der Länge L, zum Erfolg führt, sondern auch die einer anderen, das Lasersystem beeinflussenden Größe, also z.B. die der Pumpenergie, speziell des Pumpstromes I; und zudem bringt die Modulation auch andere große Vorteile, wie später genauer beschrieben wird.

Im folgenden werden Ausführungsbeispiele der Erfindung unter Verwendung eines Halbleiterlasers anhand von Zeichnungen näher erläutert:

Fig.1 zeigt den Aufbau des Laser-Sensors zur Messung von Länge L und Verkippwinkel α.

Fig.2 zeigt die auftretenden impulsförmigen Lichtintensitätsschwankungen im Signal s bei Veränderung der Länge L.

Fig.3 zeigt die dreieckförmige Modulation der Länge L, die auftretenden Impulse in s, und Verschiebung der Impulse gegenüber dem Modulationsignal.

Fig.4 zeigt die dreieckförmige Modulation des Pumpstroms I und die auftretenden Signale an s.

Fig.5 zeigt den Aufbau des Laser-Sensors zur Messung des Brechungsindex n im Raum N.

Fig.6 zeigt die Anwendung des Laser-Sensors als Autokollimator. Detaillierte Beschreibung der Erfindung

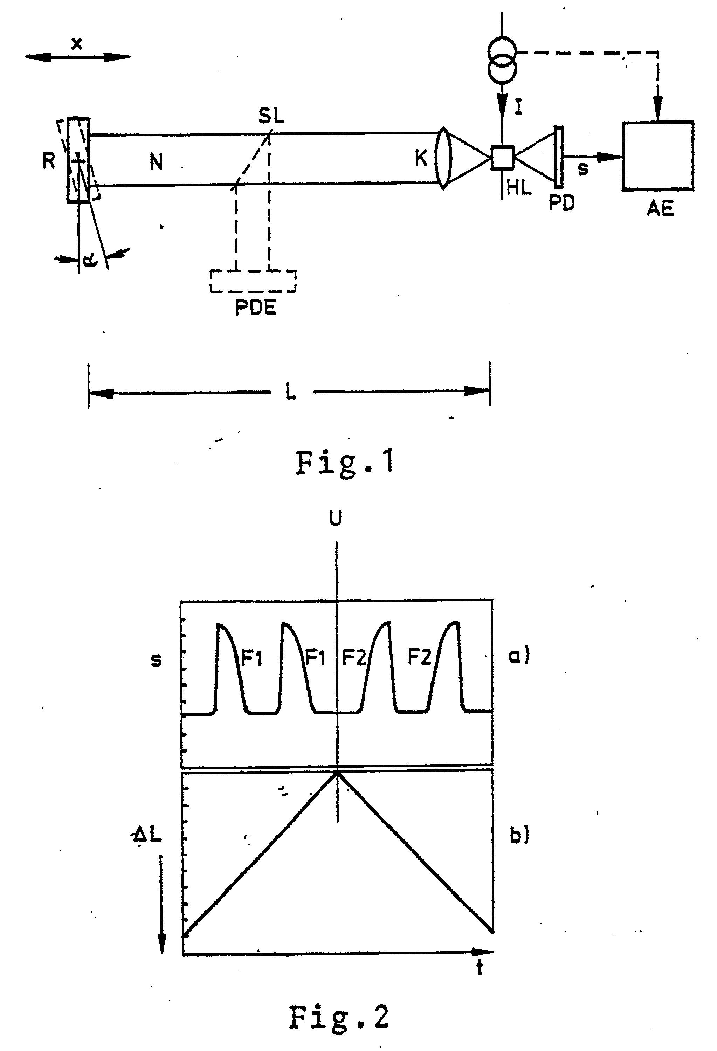

Ein erstes Ausführungsbeispiel der Erfindung zeigt Fig.1.

Ein Laser, hier speziell ein Halbleiterlaser HL wird mit einem Strom I gepumpt und sendet üblicherweise an Vorder- und Rückseite Laserlicht der Wellenlänge λ aus, sobald der Strom I die sog. Laserschwelle überschreitet.

Als Laser können z.B> die Laserdioden Sharp LT 30, LT 26 und Phillips CQL 20 verwendet werden, die die Photodiode PD in ihrem Gehäuse integriert haben.

Der Laserstrahl an der Vorderseite wird hier über einen Kollimator K gebündelt, für den sich käufliche Kollimatoren ebenso eignen wie Mikroscopobjektive oder Konvexlinsen mit möglichst kurzer Brennweite, wobei der Austrittskanal des Lasers in den Brennpunkt des Kollimators positioniert wird, so daß der Laserstrahl möglichst gut parallelisiert wird.

Die Verwendung einer einzigen Linse hat sich hier als günstiger erwiesen als Mehrlinsensysteme.

Diese parallelisierte Strahl fällt auf einen Reflektor R, der ein einfacher Spiegel sein kann, und wird von diesem über den Kollimator K in den Laser zurückreflektiert, dazu muß der Reflektor R so justiert werden, daß er zur optischen Achse der Vorrichtung senkrecht steht.

Die Intensität des vom Laser erzeugten Lichts wird mit der Photodiode PD gemessen, die im Strahlengang des rückwärtig ausgestrahlten Laserlichts liegt, und deren Signal von einer Auswerteeinheit AE ausgewertet wird.

Die Lichtintensität des Lasers kann aber auch mit einem Strahlteiler SL und einer Photodiode PDE, wie in Fig. 1 gestrichelt gezeichnet, gemessen, und an die Auswerteeinheit AE weitergemeldet werden.

Ebenso ist es möglich, als Reflektor R eine Photodiode zu verwenden, soweit deren Oberfläche reflektierend ist, und damit die Lichtintensität des Lasers zu messen.

In einer Anordnung, die aus Halbleiterlaser HL und externem Resonator, also Raum N und Reflektor R besteht, mit, oder ohne Kollimator K, und hier "Lasersystem" genannt wird, treten unter anderem folende Effekte auf:

Stellt man einen konstanten Strom I so ein, daß der Halbleiterlaser HL im Laserbereich arbeitet, und verschiebt man den Reflektor R entlang der optischen Achse um einen Weg△ x, so stellt man in der Lichtintensität des HL, bzw. im Signal s Schwankungen fest, die bei entsprechender Justage der Anordnung und des Stromes I deutlich erkennbare Impulse sind, und immer dann auftreten, wenn der Reflektor R um einen Weg vorschoben wurde, der der Halben Wellenlänge des emittierten Laserlichts entspricht.

Dieser Effekt ermöglicht den Aufbau eines inkrementalen Längenmeßsystems, es wurden Wege über mehrere cm gemessen. Genauere Überlegungen zeigen, daß der Abstand der Impulse auch vom Brechungsindex des Mediums abhängt, das sich im, vom Laserstrahl durchsetzten Raum N des externen Resonators befindet.

Ebenso ergeben sich Impulse bei einer Verkippung der Reflektors R aus der Position senkrecht zur optischen Achse, und bei einer Variation des Stroms I.

Praktisch verwendbar ist ein solches System aber erst dann, wenn im Ausgangssignal zu erkennen ist, in welche Richtung sich der Reflektor R, oder der Brechungsindex n bewegt.

Hierzu beschreibt die Erfindung zwei Methoden, die Grundlage der ersten ist in Fig.2 zu sehen. Justiert man die Vorrichtung mit den oben genannten Halbleiterlasern wie oben beschrieben, und stellt den Strom I auf die Größe der für den Halbleiterlaser angegebenen Laserschwelle, oder darunter ein, so daß an s Impulse wie in Fig.2a auftreten, so kann man feststellen, daß die Impulse F1 bei Verkleinerung der Resonatorlänge L eine andere Form haben, als die Impulse F2 bei Verlängerung des Resonators.

Dies ist auf Hystereseffekte im Laser zurückzuführen, tritt besonders an der unteren Grenze des Laserbereichs auf, und es kann z.B. durch Differenzierung von s in der Auswerteeinheit AE festgestellt, und somit die Richtung des Effekts ermittelt werden. Voraussetzung für diese Methode ist aber, daß sich der Reflektor R, Brechungsindex n oder Winkelα nicht zu langsam ändern, da sonst die Stabilität des Systems zu schlecht wird.

Erhebliche Vorteile für die Richtungserkennung, Stabilität und Auflösung des Laser-Sensors, und damit erstmalige Möglichkeit zur praktisch verwendbaren Realisierung eines solchen Systems, bietet die Modulation des Lasersystems.

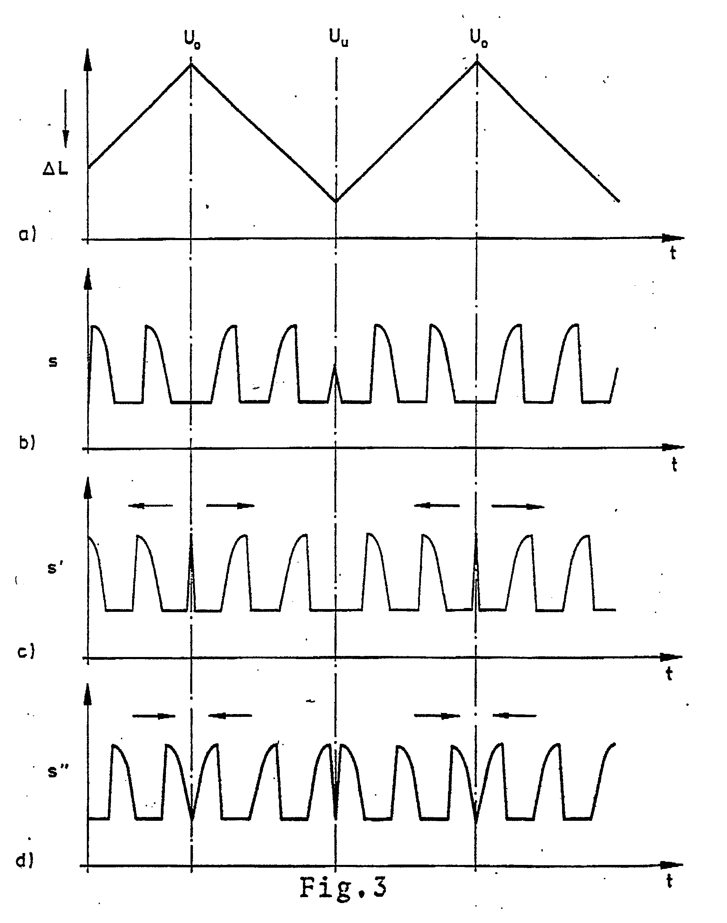

Die Modulation einer zu messenden Größe selbst ist anhand der Länge L in Fig.3 dargestellt.

Hier wird die Länge L, z.B. mit einem Piezostellglied, kontinuierlich, z.B. dreieckförmig, verändert, Fig.3a zeigt die Spannung am Piezostellglied als Maß für die Modulation von L. Dadurch entstehen ständig Impulse im Ausgangssignal s, wenn der Reflektor mindestens um die halbe Wellenlänge des Lasers ausgelenkt wird.

Die Modulation von L gibt also ein festes Zeitraster, definiert durch die Umkehrpunkte Uo und Uu, bzw. die ansteigende und abfallende Flanke des dreieckförmigen Modulationssignals. Wird das Lasersystem, außer durch die Modulation, nicht verändert, entstehen die Impulse an s, wie in Fig.3b gezeigt, immer an der selben Stelle der dreieckförmigen Längenänderung. Bewegt man aber den Reflektor R auf den Halbleiterlaser zu, so wandern die Impulse, wie in Fig.3c gezeigt von den oberen Umkehrpunkten Uo zu den unteren Umkehrpunkten Uu und verschwinden dort, während in Uo neue Impulse entstehen. Dies ist anschaulich erklärbar, da der ansteigende Teil der Modulationsspannung einer Verkürzung $\Delta$ L des externen Resonators entspricht, die durch das Bewegen des Reflektors R auf den Halbleiterlaser zu noch verstärkt wird, die Impulse kommen also früher. Die Verlängerung des ext. Resonators im fallenden Teil der Modulation von Fig.3a wird durch das Zusammenschieben von Reflektor R und Halbleiterlaser HL verzögert, dadurch kommen die Impulse hier im Vergleich zum Dreieck später.

Bewegt man nun den Reflektor R vom Halbleiterlaser HL weg, so tritt gemäß Fig.3d der umgekehrte Effekt auf, wie in Fig.3c, die Impulse wandern von den Punkten Uu nach Uo und verschwinden dort.

Zählt man nun die Zahl der verschwindenden oder entstehenden Impulse an den Umkehrpunkten, oder die Zahl und Richtung der durchlaufenden Impulse an gewissen Marken M innerhalb der Modulationsperiode, so kann man die Richtung und den Weg bestimmen, um den der Reflektor R verschoben wurde, da man weiß, daß der Abstand zweier Impulse einer Verschiebung um die halbe Laserwellenlänge entspricht ( Abgesehen vom Einfluß des Brechungsindexes n im Raum N ).

Die Auflösung von Impuls zu Impuls beträgt demnach eine halbe Laserwellenlänge, das sind bei der Sharp LT 30 380 nm.

Registriert man sogar die Verschiebung einzelner Impulse innerhalb des Modulationsintervalls zwischen den Umkehrpunkten, so läßt sich die Auflösung wieter steigern.

Eine Veränderung der Länge L, des Winkels $\alpha$, des Brechungsindex n und des Stromes I als Folge eines zu messenden Effekts oder einer gezielten Modulation zeigen in der Lichtintensität des Lasers ähnliche Wirkung, nämlich das Auftreten von Impulsen. Daher kann die Modulation zur Messung von L, $\alpha$ und n auch durch periodische Veränderung aller 4 oben genannten Größen erfolgen.

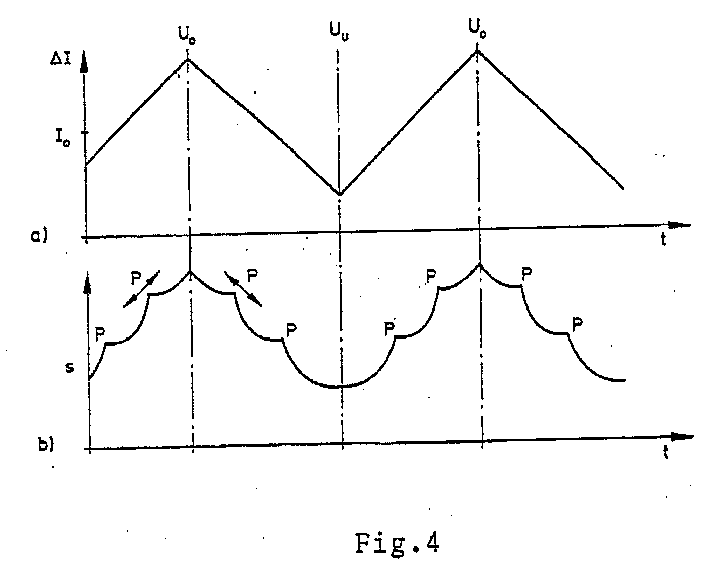

Die Modulation des Stromes I zur Längenmessung zeigt Fig 4. Hier ist die Modulation selbst im Signal s zu sehen, da der Strom I ja die Lichtintensität selbst beeinflußt, die Modulationsperiode kann also aus dem Photodiodensignal entnommen werden, und muß nicht, wie bei der Längenmodulation vom Modulator selbst in die Auswerteeinheit übertragen werden. Die Wanderung der Impulse P in Fig.4b entspricht genau der in Fig.3 und ihre Auswertung kann, wie oben beschrieben, erfolgen.

Messung des Brechungsindex

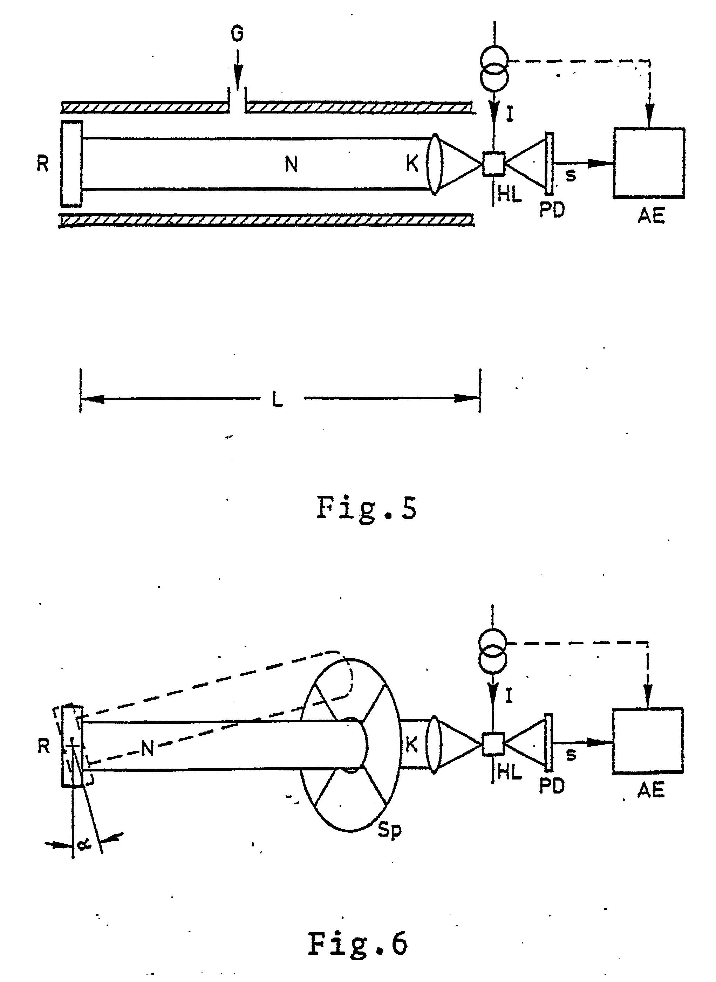

Genau dasselbe Bild, wie in Fig.4 mit derselben Wanderung der Impulse ergibt sich, wenn man, gemäß Fig.5, den Reflektor R in Ruhe läßt, und stattdessen den Brechungsindex n im externen Resonator verändert. Dies wurde z.B. realisiert, indem der ext. Resonator mit einem Rohr umgeben, und mit einem Gas ($CO_2$) geflutet wurde.

Beim Übergang an G von Luft auf $CO_2$ kann man, bei einer Resonatorlänge L von 12 cm, etwa 16 Impulse durchwandern sehen, wobei die Richtung, von Luft auf $CO_2$ und umgekehrt, eindeutig an der Wanderungsrichtung der Impulse zu erkennen ist.

Dieser beschriebene Meßeffekt eignet sich zur Analyse von Gasen, Flüssigkeiten und Festkörpern über den Brechungsindex.

Autokollimator.

Soll eine Optik, oder Vorrichtung auf Parallelität bzw. Rückstrahlung eines Strahls in sich justiert werden, ist der Aufbau nach Fig.6 geeignet, indem der Reflektor R durch das zu justierende Objekt ersetzt wird, und so lange justiert wird, bis die Effekte der maximalen Rückstrahlung in den Laser auftreten, dann steht das justierte Objekt sowohl in Zeichenebene, als auch senkrecht dazu orthogonal zur optischen Achse. Der Winkel $\alpha$, und der zu $\alpha$ korrespondierende Verkippwinkel senkrecht zur Zeichenebene (in Fig.6 nicht gezeigt) ist dann gleich null. Dies wird dadurch erreicht, daß die beiden Winkel so justiert werden, daß sich die Impulse gemäß Fig.3 bzw. Fig.4 im Punkt der Richtungsumkehr ihrer Wanderungsrichtung befinden.

Zur Grobjustage, also wenn der Laserstrahl nicht in den Laser zurückfällt, kann eine segmentierte Photodiode mit Loch Sp eingesetzt werden.

Die Modulation des Laser-Sensors bringt große Vorteile für die Stabilität des Systems, dies wurde bei praktischen Aufbauten deutlich, Hystereseeffekte und das schnelle Durchfahren von Betriebspunkten, in denen der Laser zu chaotischen Schwingungen neigt, die in der Theorie erklärt, und in Veröffentlichungen oft als Rauschen interpretiert werden, erhöhen die praktische Einsetzbarkeit des Sensors. Ebenfalls wird die Justage des Systems dadurch erheblich erleichtert, da ja, auch ohne Meßeffekt, immer Impulse auftreten. Die Vorteile sind am größten bei der Modulation des Stromes I, zudem diese Modulation bis in den GHz-Bereich schnell sein kann, und so ein sehr schnelles Längen- oder Brechungsindexmeßgerät aufgebaut werden kann.

Bei Strommodulation ergibt sich folgende Justageanweisung:
- Man erhöht den Gleichanteil des Stromes I, bis die Modulation, also z.B. das Dreieck nach Fig.4 an s meßbar ist, dann ist der Laserbereich erreicht
- dann justiert man den Kollimator K so, daß der Laserstrahl in sich, und gegenüber der optischen Achse parallel ist
- dann justiert man der Reflektor R grob so, daß der Laserstrahl in den Laser zurückfällt, und fein so, daß die in Fig.4 gezeigten Impulse P auftreten
- danach ist eine Neueinstellung des Gleichstromanteils des Stromes I möglich, um die Impulsform zu verbessern, dies hängt vom verwendeten Laser ab, und liegt in der Nähe, über oder knapp unter dem, für den Laser angegebenen Laser-Schwellenstrom.

Die Tatsache, daß der Laser-Sensor, wie hier beschrieben, unterhalb des für den Laser angegebenen Laser-Schwellenstromes arbeitet, zeigt, daß der externe Resonator tatsächlich funktioniert, und Energie in den Laser zurückkoppelt.
Die Temperaturempfindlichkeit des Halbleiterlasers kann dadurch gemindert werden, daß in regelmäßigen Abständen Parameter der Strom-Lichtleisungs- oder Strom-Spannungskennlinie, also Widerstand oder differentieller Widerstand des Halbleiterlaserchips oder der Photodiode PD gemessen werden, diese sind nämlich temperaturabhängig, und danach der Pumpstrom I entsprechend korrigiert wird. Anstatt das Durchlaufen, oder die Verschiebung von Impulsen gegenüber der Modulation zu messen, ist es auch möglich, den zu messenden Effekt durch eine zusätzliche Veränderung des Stromes I zu kompensieren, also I so zu regeln, daß die Impulse an s immer an der selben Stelle des modulationsintervalls stehen. An der zusätzlichen Veränderung von I kann dann die zu messende Größe als Analogsignal abgelesen werden.

Wie bei dieser, so kann bei allen Anwendungen des Laser-Sensors mit externem Resonator gemäß vorliegender Erfindung der Kollimator K zur Bündelung des Laserstrahls entfallen, falls der Reflektor R oder die Objekte zur Reflexion des Lasertrahls sich nahe genug am Laser befinden, und die Ansprüche an die Genauigkeit nicht sehr hoch sind.
Dadurch ergibt sich die Möglichkeit von sehr einfachen, kompakten und preiswerten Sensoren.

## Ansprüche

1. Verfahren zur Messung der Änderung der Länge ( L ) eines externen Resonators eines Lasers, einer Winkelabweichung (α) einer den Reflektor ( R ) des externen Resonators bildenden Fläche gegenüber der optischen Achse des Resonators, oder des Brechungsindex ( n ) im externen Resonator, bei dem der Strahl durch den externen Resonator hindurch auf den Reflektor ( R ) fällt und von diesem wieder zurück in den Laser reflektiert wird, wobei die Lichtintensität des Lasers bei monotoner Änderung der zu messenden Größe periodisch schwankt und aus der Anzahl der Perioden der Schwankungen der Lichtintensität die zu messende Änderung der Größe bestimmt wird,
dadurch gekennzeichnet,
daß die Erkennung der Richtung der Änderung der zu messenden Größe durch die Auswertung der richtungsabhängigen Signalform der auftretenden periodischen Schwankungen der Lichtintensität erfolgt.

2. Verfahren zur Messung der Änderung der Länge ( L ) eines externen Resonators eines Lasers, einer Winkelabweichung (α) einer den Reflektor ( R ) des externen Resonators bildenden Fläche gegenüber der optischen Achse des Resonators, oder des Brechungsindex ( n ) im externen Resonator, bei dem der Strahl durch den externen Resonator hindurch auf den Reflektor ( R ) fällt und von diesem wieder zurück in den Laser reflektiert wird, wobei die Lichtintensität des Lasers bei monotoner Änderung der zu messenden Größe periodisch schwankt und aus der Anzahl der Perioden der Schwankungen der Lichtintensität die zu messende Änderung der Größe bestimmt wird,
dadurch gekennzeichnet,
daß mindestens eine der Größen Länge ( L ) des externen Resonators, Winkelabweichung (α), Brechungsindex ( n ) oder Pumpenergie des Lasers moduliert wird, die nicht die zu messende Größe selbst sein muß, und aus der Verschiebung der durch die zu messende Größe ( L ),(α),( n ), verursachten Lichtleistungsschwankungen gegenüber der Modulation, die Richtung der Änderung der zu messenden Größe bestimmt wird.

3. Verfahren nach Anspruch 1 oder 2
dadurch gekennzeichnet,
daß der Laser strompumpt ist

4. Verfahren nach Anspruch 2
dadurch gekennzeichnet,
daß die Verschiebung der, durch die zu messende Größe Länge ( L ), Winkelabweichung (α), Brechungsindex ( n ) verursachten Lichtleistungsschwankungen gegenüber der Modulation zur Bestimmung der Änderung der zu messenden Größe selbst benutzt wird.

5. Verfahren nach einem der Ansprüche 2 bis 4

dadurch gekennzeichnet,
daß die Modulation periodisch erfolgt.

6. Verfahren nach einem der Ansprüche 2 bis 5 dadurch gekennzeichnet,
daß die Modulation dreieckförmig erfolgt.

7. Verfahren nach einem der oben genannten Ansprüche
dadurch gekennzeichnet,
daß zur Temperaturstabilisierung während der Messung zyklisch Kennlinienparameter des Lasers oder des photoempfindlichen Elements, das die Lichtleistung des Lasers mißt, bei gewissen Arbeitspunkten bestimmt, und die Pumpenergie danach korrigiert wird.

8. Verfahren nach einem der oben genannten Ansprüche
dadurch gekennzeichnet,
daß die Messung von Richtung und Betrag der Änderung von Länge ( L ), Winkel ($\alpha$), Brechungsindex ( n ) im externen Resonator mittels der Pumpenergie dadurch erfolgt, daß die Pumpenergie des Lasers so geregelt wird, daß die Wirkung der zu messenden Größen auf die Lichtleistungsschwankungen des Lasers durch die Pumpenergie kompensiert werden.

9. Einrichtung zur Durchführung des Verfahrens nach einem der Ansprüche 1 bis 8
mit einem Laser, der einen externen Resonator besitzt und mit einem Photosensor
dadurch gekennzeichnet,
daß die Intensität des Lasers mit Hilfe des Strahls gemessen wird, der den Laser an der, dem externen Resonator gegenüberliegenden Seite verläßt.

10. Einrichtung nach Anspruch 9
dadurch gekennzeichnet,
daß der Laser und der Photosensor in einem gemeinsamen Gehäuse untergebracht sind.

11. Einrichtung zur Durchführung des Verfahrens nach einem der Ansprüche 1 bis 8
dadurch gekennzeichnet,
daß der Reflektor ( R ) eine photoempfindliche Schicht zur Messung der Lichtintensität des Lasers hat.

12. Einrichtung zur Durchführung des Verfahrens nach den Ansprüchen 1 bis 8
dadurch gekennzeichnet,
daß der Reflektor ( R ) eine Photodiode ist, mit der die Lichtintensität des Lasers gemessen wird.

13. Einrichtung zur Durchführung des Verfahrens nach einem der Ansprüche 1 bis 8
dadurch gekennzeichnet,
daß der Refkeltor ( R ) einen Retroreflektor enthält.

14. Einrichtung nach den Ansprüchen 9 und 10
dadurch gekennzeichnet,
daß der Reflektor ( R ) einen Retroreflektor enthält.

15. Verfahren nach einem der Ansprüche 1 bis 8
dadurch gekennzeichnet,

daß der Strahl des Lasers mit einem Kollimator kollimiert wird.

16. Einrichtung nach einem der Ansprüche 9 bis 14
dadurch gekennzeichnet,
daß ein Kollimator im Laserstrahl angeordnet ist.

17. Verfahren nach Anspruch 15
dadurch gekennzeichnet,
daß der kollimierte Laserstrahl parallel ist.

18. Einrichtung zur Durchführung des Verfahrens nach einem der Ansprüche 1 bis 8
dadurch gekennzeichnet,
daß die Messung der Lichtintensität so erfolgt, daß ein Teil des Laserstrahls mit einem Strahlteiler auf einen Photosensor geleitet wird.

19. Einrichtung zur Durchführung des Verfahrens nach einem der Ansprüche 1 bis 8
dadurch gekennzeichnet,
daß der Laser ein Halbleiterlaser ist.

Fig.1

Fig.2

Fig.3

Fig.4

Fig.5

Fig.6

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| D,A | US-A-4 806 778  (O. YAMAMOTO et al.) <br> * Zusammenfassung; Figuren 1-3 * <br> --- | 1-19 | H 01 S    3/085 <br> G 01 D    5/26 |
| A | EP-A-0 167 277  (SHARP) <br> * Zusammenfassung; Figuren 1-3 * <br> --- | 1-19 | |
| D,A | JOURNAL OF LIGHTWAVE TECHNOLOGY, Band LT-1, Nr. 1, März 1983, Seiten 81-93; R.O. MILES et al.: "An external cavity diode laser sensor" <br> * Zusammenfassung; Figur 8 * <br> --- | 1,2 | |
| D,A | JOURNAL OF LIGHTWAVE TECHNOLOGY, Band 6, Nr. 10, Oktober 1988, Seiten 1610-1618; E.M. STRZELECKI et al.: "Investigation of tunable single frequency diode lasers for sensor applications" <br> * Zusammenfassung; Figuren 1,6,7 * <br> ----- | 1,2 | |

**RECHERCHIERTE SACHGEBIETE (Int. Cl.5)**

H 01 S
G 01 B
G 01 D

Der vorliegende Recherchenbericht wurde für alle Patentansprüche erstellt

| Recherchenort | Abschlußdatum der Recherche | Prüfer |
|---|---|---|
| DEN HAAG | 28-09-1990 | MALIC K. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
........................................................................
& : Mitglied der gleichen Patentfamilie, übereinstimmendes Dokument

EPO FORM 1503 03.82 (P0403)